# EUROPEAN PATENT APPLICATION

(11) **EP 2 048 207 A1**
(43) Date of publication of application: **15.04.2009**
(21) Application number: 07425635.5
(22) Date of filing: 11.10.2007
(51) Int. Cl.: C09G 1/02

(54) **Method of planarizing chalcogenide alloys, in particular for use in phase change memory devices**

(71) Applicant: STMicroelectronics S.r.l., 20041 Agrate Brianza (MI) (IT)
(72) Inventor: Raghavan, Srini c/o Intel Corporation, Santa Clara, CA 95052 (US); Patri, Udaya c/o Intel Corporation, Santa Clara, CA 95052 (US); Mahajan, Uday c/o Intel Corporation, Santa Clara, CA 95052 (US); Anandakumar, Umashankar c/o Intel Corporation, Santa Clara, CA 95052 (US); Ramanuja, Narahari c/o Intel Corporation, Santa Clara, CA 95052 (US)
(74) Representative: Cerbaro, Elena

(57) **Abstract**

A chalcogenide alloy is planarized for forming phase change memories using a slurry which causes reduced damage to the chalcogenide films. The slurry has two different oxidants, a first oxidant having a higher oxidation reduction potential and a second oxidant having a lower oxidation reduction potential. A first oxidant may be hydrogen peroxide; a second oxidant may be potassium nitrate.

## Description

The invention relates generally to semiconductor memories using chalcogenide alloys, in particular chalcogenide alloys used in phase change memory devices.

Phase change memory devices use phase change materials, i.e., materials that may be electrically switched between a generally amorphous and a generally crystalline state or between different detectable states of local order across the entire spectrum between completely amorphous and completely crystalline states, for electronic memory application. The state of the phase change materials is also non-volatile in that, when set in either a crystalline, semi-crystalline, amorphous, or semi-amorphous state representing a resistance value, that value is retained until changed by another programming event, as that value represents a phase or physical state of the material (e.g., crystalline or amorphous). The state is unaffected by removing electrical power.

A phase change memory device includes an array of memory cells, each memory cell comprising a memory element and a selection element. Both the memory element and the selection element may be made of a chalcogenide material. The memory element and the selection element may be sandwiched between a lower electrode and an upper electrode. Select devices may also be referred to as an access device, an isolation device, or a switch.

Programming of the phase change material to alter its state or phase may be accomplished by applying voltage potentials across the electrodes, thereby generating a voltage potential across the select device and memory element. When the voltage potential is greater than the threshold voltages of select device and memory element, then an electrical current may flow through the phase change material in response to the applied voltage potentials, and may result in heating of the phase change material.

This heating may alter the memory state or phase of the phase change material, thus altering the electrical characteristic of memory material, e.g., the resistance. Thus, the memory material may also be referred to as a programmable resistive material.

The amorphous or semi-amorphous state may be associated with a "reset" state or a logic "0" value, while a crystalline or semi-crystalline state may be associated with a "set" state, or a logic "1" value. The resistance of memory material in the amorphous or semi-amorphous state is generally greater than the resistance of memory material in the crystalline or semi-crystalline state. It is to be appreciated that the association of reset and set with amorphous and crystalline states, respectively, is a convention and that at least an opposite convention may be adopted.

Using an electrical current, the memory material may be heated to a relatively higher temperature to amorphosize memory material and "reset" memory material (e.g., program memory material to "0"). Heating the volume of memory material to a relatively lower crystallization temperature may crystallize memory material and "set" memory material (e.g., program memory material to "1"). Various resistances of memory material may be achieved to store information by varying the amount of current flow and duration through the volume of memory material.

A select device may operate as a switch that is either "off" or "on" depending on the amount of voltage potential applied across the memory cell, and more particularly whether the current through the select device exceeds its threshold current or voltage, which then triggers the device into the on state. The off state is a substantially electrically nonconductive state and the on state is a substantially conductive state, with less resistance than the off state.

In the on state, the voltage across the select device is equal to its holding voltage V_{H} plus IxRon, where Ron is the dynamic resistance from the extrapolated X-axis intercept, V_{H}. For example, a select device may have threshold voltages and, if a voltage potential less than the threshold voltage of a select device is applied across the select device, then the select device may remain "off" or in a relatively high resistive state so that little or no electrical current passes through the memory cell and most of the voltage drop from selected row to selected column is across the select device. Alternatively, if a voltage potential greater than the threshold voltage of a select device is applied across the select device, then the select device "turns on," i.e., operates in a relatively low resistive state so that electrical current passes through the memory cell. In other words, one or more series connected select devices are in a substantially electrically nonconductive state if less than a predetermined voltage potential, e.g., the threshold voltage, is applied across select devices. Select devices are in a substantially conductive state if greater than the predetermined voltage potential is applied across select devices.

In the manufacture of phase change memories, a damascene process is commonly utilized. As a result, chemical mechanical planarization steps are used in some manufacturing steps to planarize a chalcogenide alloy. However, it has been found that conventional slurries utilized to planarize other materials may create defects in chalcogenide alloys. Existing slurries polish chalcogenide alloys in a mechanical fashion, resulting in residues, scratches, and defects.

The object of the invention is thus to provide a method of plananarizing chalcogenide alloys using a slurry formulation that, in some circumstances, is able to reduce the consequences of conventional slurries.

According to the present invention, there are provided a method and a slurry as defined respectively in claims 1 and 11.

For the understanding of the present invention, a preferred embodiment is now described, purely as a non-limitative example, with reference to the enclosed drawings, wherein:
Figure 1 is an enlarged, cross-sectional view of a phase change memory cell at an early stage of manufacture;
Figure 2 is an enlarged, cross-sectional view of the cell of Figure 1 at a subsequent stage of manufacture; and
Figure 3 is a system depiction diagram for one embodiment of the present invention.

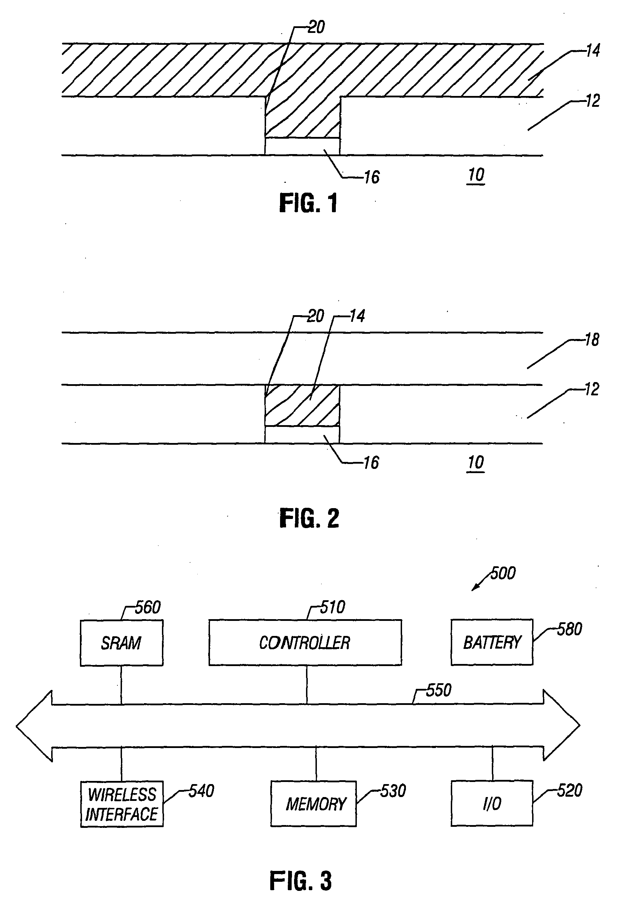

Referring to Figure 1, a substrate 10 has a conductor formed therein which may be a row line. Coupled to the row line is a heater 16 which is formed in the pore 20 of a dielectric layer 12. The heater 16 fills only the bottom of the pore 20. Then, a chalcogenide layer 14 is blanket deposited into the pore 20 and over the dielectric layer 12.

Thereafter, chalcogenide layer 14 is planarized to the structure shown in Figure 2, where the chalcogenide layer 14 is entirely within the pore 20. Planarization is performed using a chemical mechanical polishing. Thereafter, an upper conductor 18 is deposited and shaped to form, e.g., a column line.

In a chemical mechanical planarization method, a wafer is placed face down on a rotating pad while a slurry is dispensed between pad and wafer. A carrier, which is generally attached to a rotatable shaft, is used to apply a downward force against the back side of the wafer. A retaining ring may be used to center the wafer onto the carrier and to prevent the wafer from slipping laterally. By applying the downward force and rotating the wafer, while simultaneously rotating the pad having a slurry thereon, a desired amount of material is removed from the surface of the thin film. A rotating polisher, such as a Mirra Mesa polisher, available from Applied Materials, Inc., Santa Clara, CA., may be used. Other polishers, including orbital and linear polishers, may also be used.

Stacked polishing pads, such as IC 1000, with a suba-4, sub-pad, made by Rohm and Haas Electronic Materials of 3804 East Watkins Street, Phoenix, AZ 85034, may be used with the slurry. Other commercially available polishing pads may be used as well. While the above examples are given, they are in no way limiting on the scope of the present invention.

The slurry has a combination of oxidant, complexant, abrasive, acid/base, and salts; in particular, two oxidants are utilized. In one embodiment one oxidant is weaker than the other. The weaker oxidant, having an oxidation reduction potential, e.g., less than 500mV, may be potassium nitrate and the stronger oxidant, having an oxidation reduction potential, e.g., greater than 500mV, may be hydrogen peroxide. As examples, the hydrogen peroxide may be used in a concentration range of 0.5 to 10 percent, while potassium nitrate may be utilized in a concentration range of 0.5 to 5 percent. pH ranges include, but are not limited to, 2 to 6. The weight percent of silica particles may be 0.5 to 3 percent. The complexant may be a carboxylic acid or poly(carboxylic acid) or derivatives thereof, such as tartaric acid. The abrasive particle size may be from 30nm to 200nm. The acid may be nitric acid and sulfuric acid, while the base may be KOH and quaternary ammonium hydroxide. The salts may be potassium iodide, as well as a potassium sulfate. In some embodiments, a high rate of polishing (greater than 1000 Ångstroms -100 nm-per minute) may be utilized. For example, as much as 1400 Angstroms per minute may be removed, without damaging the chalcogenide alloy.

In another embodiment, region 16 forms a select device. Select device 16 is here of a switch material 16 such as, for example, a chalcogenide alloy; thus, it may be referred to as an ovonic threshold switch, or simply an ovonic switch. The switch material 16 may be a material in a substantially amorphous state positioned between two electrodes that may be repeatedly and reversibly switched between a higher resistance "off" state (e.g., greater than about ten megaOhms) and a relatively lower resistance "on" state (e.g., about one thousand Ohms in series with V_{H}) by application of a predetermined electrical current or voltage potential. In this embodiment, each select device is a two terminal device that has a current-voltage (I-V) characteristic similar to a phase change memory element that is in the amorphous state. However, unlike a phase change memory element, the switching material of select devices does not change phase. That is, the switching material of select devices is not be a programmable material, and, as a result, select devices are not memory devices capable of storing information. For example, the switching material of select devices may remain permanently amorphous and the I-V characteristic may remain the same throughout the operating life.

In the low voltage or low electric field mode, i.e., where the voltage applied across select device is less than a threshold voltage (labeled V_{TH}), a select device is "off" or nonconducting, and exhibits a relatively high resistance, e.g., greater than about 10 megaOhms. The select device remains in the off state until a sufficient voltage, e.g., V_{TH}, is applied, or a sufficient current is applied, e.g., I_{TH}, that may switch the select device to a conductive, relatively low resistance on state. After a voltage potential of greater than about V_{TH} is applied across the select device, the voltage potential across the select device drops ("snapback") to a holding voltage potential, V_{H}. Snapback refers to the voltage difference between V_{TH} and V_{H} of a select device.

In the on state, the voltage potential across the select device remains close to the holding voltage of V_{H} as current passing through the select device is increased. The select device remains on until the current through the select device drops below a holding current, I_{H}. Below this value, the select device turns off and returns to a relatively high resistance, nonconductive off state until the V_{TH} and I_{TH} are exceeded again.

In some embodiments, only one select device is used. In other embodiments, more than two select devices are used. A single select device may have a V_{H} about equal to its threshold voltage, V_{TH}, (a voltage difference less than the threshold voltage of the memory element) to avoid triggering a reset bit when the select device triggers from a threshold voltage to a lower holding voltage called the snapback voltage. In an another example, the threshold current of the memory element may be about equal to the threshold current of the access device even though its snapback voltage is greater than the memory element's reset bit threshold voltage.

While an embodiment includes using the present slurry for polishing a memory region of a phase change memory is described herein, other uses of the present slurry may include polishing ovonic threshold switches and chalcogenide memories with multiple states.

Turning to Figure 3, a portion of a system 500 in accordance with an embodiment of the present invention is described. System 500 may be used in wireless devices such as, for example, a personal digital assistant (PDA), a laptop or portable computer with wireless capability, a web tablet, a wireless telephone, a pager, an instant messaging device, a digital music player, a digital camera, or other devices that may be adapted to transmit and/or receive information wirelessly. System 500 may be used in any of the following systems: a wireless local area network (WLAN) system, a wireless personal area network (WPAN) system, a cellular network, although the scope of the present invention is not limited in this respect.

System 500 includes a controller 510, an input/output (I/O) device 520 (e.g. a keypad, display), static random access memory (SRAM) 560, a memory 530, and a wireless interface 540 coupled to each other via a bus 550. A battery 580 may be also present.

Controller 510 may comprise, for example, one or more microprocessors, digital signal processors, microcontrollers, or the like. Memory 530 may be used to store messages transmitted to or by system 500. Memory 530 may also optionally be used to store instructions that are executed by controller 510 during the operation of system 500, and may be used to store user data. Memory 530 may be provided by one or more different types of memory. For example, memory 530 may comprise any type of random access memory, a volatile memory, a non-volatile memory such as a flash memory, in addition to a memory such as memory discussed herein.

I/O device 520 may be used by a user to generate a message. System 500 may use wireless interface 540 to transmit and receive messages to and from a wireless communication network with a radio frequency (RF) signal. Examples of wireless interface 540 may include an antenna or a wireless transceiver, although the scope of the present invention is not limited in this respect.

Finally, it is clear that numerous variations and modifications may be made to the method described and illustrated herein, all falling within the scope of the invention as defined in the attached claims.

## Claims

1. A method comprising:
polishing a chalcogenide alloy using a slurry having two different oxidants.

2. The method of claim 1, including using a first oxidant having a higher oxidation reduction potential and a second oxidant having a lower oxidation reduction potential.

3. The method of claim 2, wherein said first oxidant has an oxidation reduction potential greater than 500mV and the second oxidant has an oxidation reduction potential less than 500mV.

4. The method of claim any of claims 1-3, including using as one of said oxidants hydrogen peroxide.

5. The method of claim 4, including using as the other oxidant potassium nitrate.

6. The method of any of claims 1-5, including polishing at a rate greater than 1000 Angstroms (100 nm) per minute.

7. The method of any of claims 1-6, including using nitric acid and sulfuric acid in the slurry.

8. The method of any of claims 1-7, including using a slurry pH of from 2 to 6.

9. The method of any of claims 1-8, including using tartaric acid in said slurry.

10. The method of any of claims 1-9, including using an abrasive particle size of from 30 to 200nm.

11. A slurry comprising:
at least two oxidants, one of said oxidants having a higher oxidation reduction potential than the other of said oxidants.

12. The slurry of claim 11, including a first oxidant having an oxidation reduction potential greater than 500mV and the second oxidant having an oxidation reduction potential less than 500mV.

13. The slurry of claim 11 or 12, wherein one of said oxidants is hydrogen peroxide.

14. The slurry of claim 11 or 12, wherein one of said oxidants is potassium nitrate.

15. The slurry of any of claims 11-14, including an abrasive particle size of from 30 to 200nm.

16. The slurry of any of claims 11-15, including tartaric acid.
